# EUROPÄISCHE PATENTSCHRIFT

(11) **EP 1 956 643 B1**
(45) Veröffentlichungstag und Bekanntmachung des Hinweises auf die Patenterteilung: **09.04.2014**
(21) Anmeldenummer: 07024113.8
(22) Anmeldetag: 12.12.2007
(51) Int. Cl.: H01L 21/306

(54) **Verfahren zur Verringerung und Homogenisierung der Dicke einer Halbleiterschicht, die sich auf der Oberfläche eines elektrisch isolierenden Materials befindet**
Method for reducing and homogenising the thickness of a semiconductor layer on the surface of an electrically insulating material
Procédé de réduction et d'homogénéisation de l'épaisseur d'une couche semi-conductrice, qui se trouve sur la surface d'un matériau électriquement isolant

(30) Priorität: 07.02.2007 DE 102007006151
(43) Veröffentlichungstag der Anmeldung: 13.08.2008
(73) Patentinhaber: Siltronic AG, 81737 München (DE)
(72) Erfinder: Feijóo, Diego, Dr., 84489 Burghausen (DE); Riemenschneider, Oliver, Dr., 24159 Kiel (DE); Wahlich, Reinhold, 84529 Tittmoning (DE)
(74) Vertreter: Baar, Christian

(56) Entgegenhaltungen:
- EP-A- 0 553 855
- EP-A- 1 251 556
- US-A1- 2002 001 968
- US-A1- 2005 079 714

## Beschreibung

Die vorliegende Erfindung bezieht sich auf ein Verfahren zum Dünnen und Einebnen einer Halbleiterschicht mittels einer Ätzbehandlung mit lokal unterschiedlichem Materialabtrag.

Ein Beispiel für eine technologisch relevante Halbleiterschicht ist die Funktionsschicht einer SOI-Scheibe (SOI = "Semiconductor on Insulator" oder "Silicon on Insulator"). SOI-Scheiben weisen als Funktionsschicht eine Halbleiterschicht auf, beispielsweise eine Siliciumschicht, die sich auf einer Fläche einer Trägerscheibe (engl. "base wafer" oder "handle wafer") befindet. Die Dicke der Halbleiterschicht variiert abhängig von den zu prozessierenden Bauelementen. Generell wird zwischen sog. "dünnen Schichten" (weniger als 100 nm Dicke) und sog. "dicken Schichten" (von 100 nm bis ca. 80 µm Dicke) unterschieden. Die Trägerscheibe kann entweder vollständig aus einem elektrisch isolierenden Material bestehen (z.B. Glas, Quarz, Saphir) oder sie kann beispielsweise aus einem Halbleitermaterial, vorzugsweise aus Silicium, bestehen und lediglich durch eine elektrisch isolierende Schicht von der Halbleiterschicht getrennt sein. Die elektrisch isolierende Schicht kann beispielsweise aus Siliciumoxid bestehen.

Die Halbleiterschicht einer SOI-Scheibe muss eine sehr homogene Dicke bis in den äußersten Randbereich aufweisen. Insbesondere bei Halbleiterschichten mit einer Dicke von 100 nm oder weniger variieren die Transistoreigenschaften, wie z.B. die Einsatzspannung, im Fall inhomogener Schichtdicken sehr stark. Die absolute Dickentoleranz bei SOI-Scheiben mit dünnen und dicken Halbleiterschichten hängt von der Schichtdicke ab.

Um eine möglichst große Anzahl von Schaltkreisen integrieren zu können, muss zudem die notwendige Schichtdickenhomogenität möglichst nahe bis an den Rand der Vorderseite gewährleistet sein. Dies bedeutet wiederum einen sehr geringen Randausschluss. Als Vorderseite einer SOI-Scheibe wird die Seite bezeichnet, die die Funktionsschicht trägt, auf der bzw. in der später elektronische Bauelemente hergestellt werden.

Alle bekannten Verfahren zur Herstellung von SOI-Scheiben versuchen, eine ausreichende Homogenität der Halbleiterschicht direkt einzustellen, aber für extreme Anforderungen kann es notwendig werden, zur weiteren Verbesserung der Dickenhomogenität eine Nachbehandlung der fertigen oder teilprozessierten SOI-Scheibe durchzuführen.

Im Stand der Technik sind mehrere Verfahren zur Nachbehandlung einer SOI-Scheibe mit dem Ziel der Verbesserung der Schichtdickenhomogenität bekannt. Bei manchen dieser Verfahren handelt es sich um lokale Ätzverfahren unter Abrastern der SOI-Scheibe, wobei an Stellen höherer Schichtdicke ein höherer Ätzabtrag vorgesehen ist: Gemäß US2004/0063329A1 wird in einem Trockenätzverfahren die Oberfläche der SOI-Scheibe mit einer Düse abgerastert, über die ein gasförmiges Ätzmedium lokal zugeführt wird. In EP488642A2 und EP511777A1 sind Verfahren beschrieben, in denen die Halbleiterschicht der SOI-Scheibe ganzflächig einem Ätzmedium ausgesetzt wird. Dieses Ätzmedium muss jedoch durch einen Laserstrahl oder einen mit einem optischen System fokussierten Lichtstrahl einer Lichtquelle lokal unter Abrastern der Oberfläche aktiviert werden (photochemisches Ätzen).

Alle Verfahren, bei denen die Oberfläche der Halbleiterschicht abgerastert werden muss, um einen lokal unterschiedlichen Ätzabtrag zu erreichen, sind sehr zeit- und damit kostenintensiv. Außerdem erfordert das Abrastern eine aufwändige Bewegung der Lichtquelle bzw. der Düse einerseits oder der SOI-Scheibe andererseits.

Zudem treten besonders im Randbereich der Scheibe, d.h. in einem Bereich bis zu 5 mm Entfernung vom Scheibenrand sowie in den Bereichen, in denen beim Abrastern die Überlappung geschieht, zusätzliche Inhomogenitäten der Schichtdicke auf. Bei einer Schichtdicke von 520 nm wird gemäß EP488642A2 eine Schichtdickenhomogenität von 10 nm ohne Angabe eines Randausschlusses erreicht. Gemäß EP511777A1 wird bei einer Schichtdicke von 108 nm eine Schichtdickenhomogenität von 8 nm ohne Angabe eines Randausschlusses erreicht.

In DE102004054566A1 wird ein Verfahren zum Einebnen einer Halbleiterschicht beschrieben, bei dem - nach ortsabhängiger Messung der Dicke der Halbleiterschicht - unter Belichtung der gesamten Fläche der SOI-Scheibe die Scheibe geätzt wird. Die Abtragsrate der Ätzbehandlung ist abhängig von der Lichtintensität an der Fläche der Halbleiterscheibe, und die Lichtintensität wird ortsabhängig so vorgegeben, dass die Unterschiede in der vorher gemessenen ortsabhängigen Schichtdicke durch die ortsabhängige Abtragsrate verringert werden. Diese Methode gleicht sehr effektiv lokale Dickenunterschiede der Halbleiterschicht aus, aber sie erfordert zusätzlichen Aufwand, der die Kosten erhöht: Eine Dickenmessung vor dem Ätzen, die Erzeugung einer Maske für die Belichtung sowie eine Belichtungsvorrichtung.

In JP09-008258A wird ein Verfahren beschrieben, bei dem die Siliciumschicht einer SOI-Scheibe bei gleichzeitiger Belichtung der gesamten Fläche geätzt und deren Dicke homogenisiert wird. Der Prozess ist selbstregulierend, weil die Ätzrate abhängig ist von der Anzahl an Löchern (d.h. Defektelektronen, d.h. positiven Ladungsträgern), die durch das Licht generiert werden, und somit von dem beleuchteten Volumen und folglich von der lokalen Silicium-Schichtdicke über der isolierenden Schicht. Ab einer bestimmten Restdicke der Siliciumschicht reicht die Menge der vom Licht erzeugten Ladungsträger nicht mehr aus, und die Dünnung stoppt. Da die Absorption des Lichts in der Siliciumschicht auch von der Wellenlänge des Lichts abhängig ist, ermöglicht es dieser Ansatz auch, unterschiedliche Restdicken der Siliciumschicht einzustellen. Dieses Verfahren braucht somit keine externe ortsabhängige Regulierung der Lichtintensität und somit auch keine Dickenmessung vor dem Ätzen und keine Maske, aber die Ätzvorrichtung muss immer noch so aufwendig gebaut sein, dass Lichteinstrahlung möglich ist.

Die Aufgabe der Erfindung besteht somit darin, die Halbleiterschicht einer SOI-Scheibe zu homogenisieren, ohne aufwändige Zusatzeinrichtungen wie Beleuchtungsvorrichtungen zu benötigen.

Die Aufgabe wird gelöst, siehe Anspruch 1, durch ein Verfahren zur Verringerung und Homogenisierung der Dicke einer Funktionsschicht aus Silicium, die sich auf der Oberfläche eines elektrisch isolierenden Materials befindet und die Funktionsschicht einer SOI-Scheibe ist, wobei ein Ätzmittel auf die Oberfläche der Funktionsschicht einwirkt, das Fluorwasserstoff und ein Fluoridsalz enthält und dessen Redoxpotential in Abhängigkeit von der gewünschten Enddicke der Funktionsschicht so eingestellt ist, dass der durch das Ätzmittel an der Oberfläche der Funktionsschicht pro Zeiteinheit bewirkte Materialabtrag mit abnehmender Dicke der Funktionsschicht geringer wird und bei der gewünschten Enddicke nur mehr 0 bis 10 % der Dicke pro Sekunde beträgt, und wobei das Verfahren ohne Gebrauch von Lichtquellen, die durch Erzeugen von Ladungsträgern signifikant zur Ätzreaktion beitragen, oder Anlegen einer externen elektrischen Spannung durchgeführt wird.

Das erfindungsgemäße Verfahren ist auf Funktionsschichten aus Silicium anwendbar, die auf der Oberfläche eines elektrisch isolierenden Materials aufgebracht sind, also für alle SOI-Scheiben mit Funktionsschicht aus Silicium. Das erfindungsgemäße Verfahren kann auch angewandt werden, wenn die Funktionsschicht aus p-dotiertem Silicium besteht. Das Verfahren kann auch zum Dünnen und Homogenisieren von SOI-Schichten mit einer Dicke von mehr als 1 µm verwendet werden, die z.B. nach dem Bonden von Donor- und Trägerscheibe durch einseitiges Schleifen oder Ätzen hergestellt wurden und für bestimmte Anwendungen zu große Dickenschwankungen der Funktionsschicht aufweisen. Das elektrisch isolierende Material unter der Funktionsschicht ist in der Regel Siliciumoxid, es sind aber auch andere Materialien wie Metalloxide oder Nitride verwendbar.

Das Verfahren wird bei einer durch Übertragung einer Halbleiterschicht von einer Donorscheibe auf eine Trägerscheibe hergestellten SOI-Scheibe nach dem Verbinden der Scheiben und Trennen der Schicht vom Rest der Donorscheibe durchgeführt. Das erfindungsgemäße Verfahren kann mit einem oder mehreren thermischen Prozessen zur Oberflächenglättung oder zur Verstärkung der Bondkraft und/oder mit einer oder mehreren Oxidationsbehandlungen zur Dünnung der Funktionsschicht kombiniert werden. Bevorzugt wird im Anschluss an das erfindungsgemäße Verfahren keine Politur durchgeführt, um die Ebenheit nicht wieder zu verschlechtern.

Das Verfahren kann auch bei SOI-Scheiben angewendet werden, die nicht durch Übertragung einer Halbleiterschicht sondern durch andere Technologien wie z.B. SIMOX hergestellt wurden. Das Verfahren kann auch angewendet werden, wenn die Funktionsschicht nicht über die gesamte Scheibe sondern nur lokal vorhanden ist. In diesem Fall kann es notwendig sein, manche Bereiche der Scheibe gegen die Ätzwirkung zu schützen.

Das erfindungsgemäße Verfahren wird ohne die Einwirkung von Licht durchgeführt. Dies macht eine an die besonderen Erfordernisse einer Bestrahlung angepasste Ätzvorrichtung überflüssig. Für die Durchführung des erfindungsgemäßen Verfahrens kann daher eine herkömmliche Ätzvorrichtung verwendet werden, in der eine einzelne SOI-Scheibe oder gleichzeitig mehrere SOI-Scheiben behandelt werden können. Selbstverständlich bedeutet "ohne Einwirkung von Licht" nicht, dass das Verfahren in völliger Dunkelheit durchgeführt werden muss. Die Einwirkung von Tageslicht oder üblichem, zur Raumbeleuchtung eingesetzten Kunstlicht hat keinerlei Einfluss auf den Erfolg und die Wirtschaftlichkeit des erfindungsgemäßen Verfahrens und ist selbstverständlich zulässig. Das erfindungsgemäße Verfahren macht aber keinen Gebrauch von Lichtquellen, die durch ihre Intensität und Wellenlänge Ladungsträger in der Funktionsschicht erzeugen, die zur Ätzreaktion signifikant beitragen.

Das erfindungsgemäße Verfahren wird ohne Anlegen einer äußeren elektrischen Spannung durchgeführt.

Das Verfahren wird mit einem flüssigem Ätzmittel durchgeführt, das Fluorwasserstoff und ein Fluoridsalz enthält. Erfindungsgemäß wird das Redoxpotential des Ätzmittels so eingestellt, dass entweder der durch das Ätzmittel an der Oberfläche der Halbleiterschicht bewirkte Materialabtrag selbstständig zum Stillstand kommt, sobald die gewünschte Enddicke der Halbleiterschicht erreicht wird, oder dass der Materialabtrag bei der gewünschten Enddicke so langsam wird, dass der Ätzprozess nach einer bestimmten Zeit extern unterbrochen werden kann (z.B. durch Entnehmen der Scheibe aus dem Ätzmittel), ohne dass dabei die gewünschte Enddicke für praktische Zwecke signifikant über- oder unterschritten wird. Die maximale "Unschärfe" beim externen Unterbrechen der Ätzreaktion sollte nicht mehr als 10 % der gewünschten Enddicke betragen. Da die Zeit zum manuellen Stoppen der Ätzreaktion maximal eine Sekunde beträgt (z.B. für das Entnehmen der Scheibe aus dem Ätzmittel), ist es im Sinne der Erfindung ausreichend, wenn der Ätzabtrag bei der gewünschten Enddicke der Halbleiterschicht so gering ist, dass er nur mehr zwischen 0 und 10 % der Dicke der Halbleiterschicht pro Sekunde beträgt. In absoluten Zahlen ausgedrückt, sollte die Ätzrate bei Erreichen der gewünschten Enddicke der Halbleiterschicht vorzugsweise zwischen 0 und 1 nm pro Sekunde betragen.

Ein geeignetes Redoxpotential kann, wie weiter unten beschrieben wird, durch eine geeignete Wahl der Zusammensetzung des Ätzmittels erreicht werden. Insbesondere können die Komponenten des Ätzmittels oder deren Konzentrationen oder beides geeignet gewählt werden. In den meisten Fällen wird das Redoxpotential des Ätzmittels im Wesentlichen durch seinen pH-Wert bestimmt. In diesen Fällen werden die Konzentrationen der Komponenten des Ätzmittels so gewählt, dass ein geeigneter pH-Wert eingestellt wird.

Es ist möglich, den pH-Wert des Ätzmittels zum Beginn der erfindungsgemäßen Ätzbehandlung so zu wählen, dass eine vergleichsweise hohe Abtragsrate resultiert. Im Laufe der Ätzbehandlung kann der pH-Wert des Ätzmittels und damit sein Redoxpotential, vorzugsweise durch Zugabe (d.h. Konzentrationserhöhung) einer seiner Komponenten anschließend so verändert werden, dass bei Erreichen der gewünschten End-Schichtdicke die Ätzrate im erfindungsgemäßen Bereich liegt. Vorzugsweise wird der pH-Wert während der Ätzbehandlung jedoch nicht verändert, d.h. es werden vorzugsweise keine Stoffe zugegeben, während die Ätzbehandlung durchgeführt wird.

Das Redoxpotential ist weiterhin abhängig von der Temperatur. Nach der Nernst'schen Gleichung ist das Redoxpotential proportional zur Temperatur. Dadurch kann die gewünschte Enddicke zusätzlich beeinflusst werden.

Es enthält das Ätzmittel Fluorwasserstoff (HF) und ein Fluoridsalz. Aus praktischen Gründen wird bevorzugt Wasser als Lösungsmittel verwendet, ohne dass Wasser ein zwingender Bestandteil ist. Das Fluoridsalz ist vorzugsweise Ammoniumfluorid (NH₄F). Andere Salze sind prinzipiell auch möglich, aber NH₄F hat die Vorteile, dass es in der Halbleiterindustrie verwendet wird und somit in den nötigen Spezifikationen erhältlich ist, dass es im Gemisch mit HF die Einstellung des pH-Wertes ermöglicht und dass es im Gemisch mit HF als pH-Wert-Puffer dient.

Das erfindungsgemäße Verfahren wird im Folgenden für SOI-Scheiben mit Funktionsschichten aus Silicium und Ätzmittel auf der Basis von HF und NH₄F im Detail beschrieben.

### Kurzbeschreibung der Figuren

Fig. 1: Bandverbiegung in p-dotiertem Silicium bei Kontakt mit Flusssäure (Fluorwasserstoff, HF, in wässriger Lösung).
Fig. 2: Bandverbiegung in n-dotiertem Silicium bei Kontakt mit Flusssäure (Fluorwasserstoff, HF, in wässriger Lösung).
Fig. 3: Verlauf der Raumladungszone in Silicium-Volumenmaterial.
Fig. 4: Verlauf der Raumladungszone in der aus Silicium bestehenden Funktionsschicht einer SOI-Scheibe.
Fig. 5: Skizzierter Verlauf der Bandverbiegung innerhalb einer Siliciumscheibe bei Kontakt mit einer wässrigen HF-Lösung.
Fig. 6: Skizzierter Verlauf der Bandverbiegung innerhalb einer Siliciumscheibe bei Kontakt mit einer wässrigen Ammoniumfluorid-Lösung (NH₄F).
Fig. 7: Abhängigkeit der Ätztiefe d (in nm) in der 100 nm dicken Siliciumschicht einer SOI-Scheibe vom pH-Wert der eingesetzten wässrigen Ätzlösung mit einer Mischung aus 5%iger HF- und 5%iger NH₄F bei einer Temperatur von 25 °C nach einer Ätzzeit von t = 5 min. Die Kurve stellt eine exponentielle Anpassung der Abhängigkeit dar.
Fig. 8: Verlauf der Ätztiefe d (in nm) mit der Reaktionszeit t (in min) für eine wässrige Ätzlösung mit einer Mischung aus 10%iger HF- und 10%iger NH₄F-Lösung auf der 100 nm dicken Siliciumschicht einer SOI-Scheibe. Der pH-Wert wurde bei einem Wert von 5,5 eingestellt. Die Temperatur wurde bei 25 °C gehalten. Die gerade Linie stellt eine lineare Extrapolation der Messwerte bis t = 60 min dar.
Fig. 9: Verlauf der Ätztiefe d (in nm) mit der Reaktionszeit t (in min) bei einer 2200 nm dicken Siliciumschicht einer SOI-Scheibe für wässrige Ätzlösungen mit Mischungen aus 5%iger HF- und 5%iger NH₄F-Lösung und unterschiedlichen pH-Werten bei einer Temperatur von 10 °C.
Fig. 10: Verlauf der Ätztiefe d (in nm) mit der Reaktionszeit t (in min) bei einer 100 nm dicken Siliciumschicht einer SOI-Scheibe für eine wässrige Ätzlösung mit einer Mischung aus 5%iger HF- und 5%iger NH₄F-Lösung mit einem pH-Wert von 4 und einer Temperatur von 10 °C.

### Bevorzugte Ausführungsform

Silicium (Si) ist ein indirekter Halbleiter mit einer Bandlücke von 1,12 eV. Das Verhalten in Kontakt mit einem Elektrolyten kann daher sehr anschaulich mit dem Bändermodell erklärt werden. Wird z.B. Silicium in Kontakt mit wässriger Flusssäure (HF) gebracht, so kommt es zu einer Angleichung der elektrochemischen Potentiale an der Grenzfläche zwischen Silicium und Elektrolyt. Um den Austritt von frei beweglichen Ladungsträgern aus dem Silicium zu verhindern, bildet sich an der Grenzfläche eine Raumladungszone aus. Dabei bildet sich in der Raumladungszone eine Überschussladung Q in Form von ortsfesten Ladungen, d.h. es gibt dort keine frei beweglichen Ladungsträger mehr. Dieser steht auf der Elektrolytseite der Grenzfläche eine entgegengesetzte Ladung -Q in Form einer elektrolytischen Doppelschicht gegenüber. Wenn eine Lösung nicht extrem verdünnt ist, liegt in ihr eine Ladungsträgerkonzentration vor, welche die im Silicium (abhängig vom Dotiergrad) um eine Größenordung übersteigt. Somit kann die Ladung auf der Elektrolytseite in einer sehr dünnen Schicht im Bereich einiger Nanometer kompensiert werden.

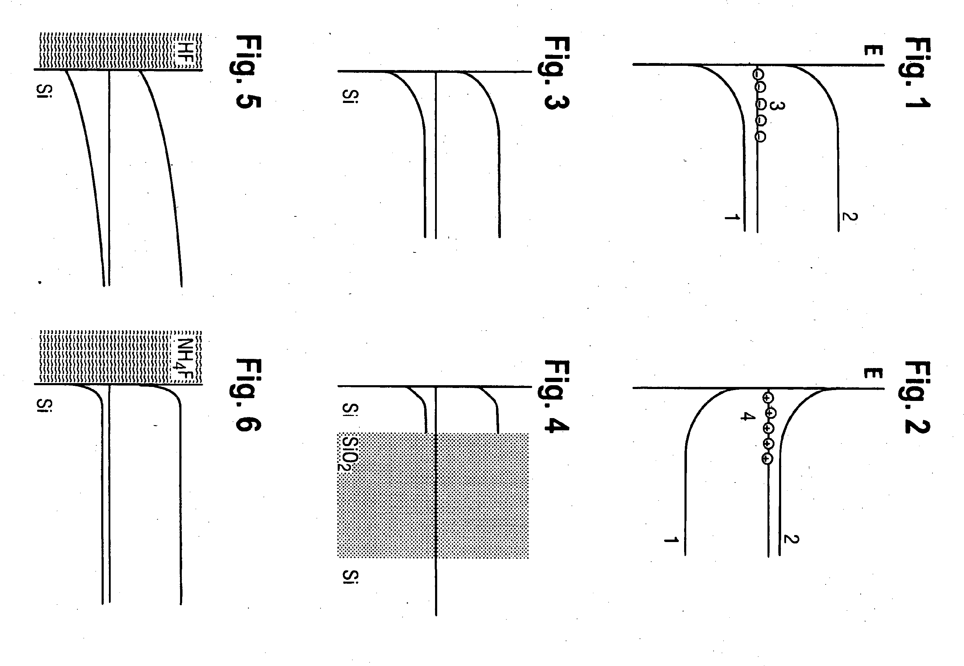

Die Raumladungszone im Silicium hingegen erstreckt sich für moderate bis niedrige Dotierungen über eine Tiefe in der Größenordnung eines Mikrometers. Das gesamte elektrische Potential, das durch die Ladung Q in der Silicium-Raumladungszone und der elektrolytischen Doppelschicht entsteht, fällt daher innerhalb des Siliciums ab. Mit diesem Potentialabfall in der Raumladungszone des Siliciums ist eine Bandverbiegung an der Grenzfläche zwischen Silicium und Elektrolyt innerhalb des Siliciums verbunden (Fig. 1, 2).

Für p-dotiertes Silicium (Fig. 1) sind Valenz- und Leitungsband (1 bzw. 2) an der Si/HF-Grenzfläche zu niedrigeren Elektronenenergien (nach unten) gekrümmt. Die Siliciumoberfläche ist daher an Löchern verarmt. Für n-dotiertes Silicium (Fig. 2) sind die Bänder dagegen zu höheren Elektronenenergien (nach oben) gekrümmt. Die Siliciumoberfläche ist an Leitungsbandelektronen verarmt. Die Symbole 3 bzw. 4 stehen für die ionisierten Dotierstoffatome.

Für den Kontakt von HF mit p-dotiertem Silicium mit einem Widerstand von 0,5 bis 1 Qcm ergibt sich eine Raumladungszonenweite von etwa 1 µm. Die Oberfläche ist zwar an Löchern verarmt, kann aber dennoch durch die HF-Lösung geätzt werden. Die benötigten Löcher kommen dabei aus dem Volumen des Siliciums, wo sie thermisch nachgeneriert werden.

Generell eröffnen sich zwei Wege, um Silicium aufzulösen. Zum einen kann Silicium direkt angegriffen und aufgelöst werden, zum anderen kann der Weg über die Bildung und Auflösung von Siliciumdioxid (SiO₂) beschritten werden. In sauren flusssäurehaltigen Lösungen führt der direkte Weg nur zu sehr geringen Ätzraten von einigen Zehntel nm/min.

Si + 2 HF₂⁻ + 2 HF ⇆ [SiF₆]²⁻ + 2 H₂ (1)

Für die Ätzung mit Flusssäure bietet sich daher ein zweistufiger Prozess an. In einem ersten Schritt wird Silicium zu Siliciumdioxid oxidiert und dieses danach durch die Flusssäure aufgelöst.

Si + 6 H₂O + 4 h⁺ ⇆ SiO₂ + 4 H₃O⁺ (2)

SiO₂ + 4 HF ⇆ SiF₄ + 2 H₂O (3)

SiF₄ + 2 HF + 2 H₂O ⇆ [SiF₆]²⁻ + 2 H₃O⁺ (4)

Die Geschwindigkeiten für diesen Reaktionsweg liegen um den Faktor 1000 bis 10000 höher als für die direkte Auflösung des Siliciums gemäß Reaktionsgleichung (1). Daher kann trotz des gleichzeitigen Auftretens beider Reaktionswege die direkte Auflösung vernachlässigt werden.

Prinzipiell können all diese Aussagen direkt auf die Siliciumschicht einer SOI-Scheibe übertragen werden, denn es handelt sich weiterhin um eine Grenzfläche HF/Si. Dennoch lässt sich das Verhalten nicht mit dem des Volumenmaterials vergleichen. Der entscheidende Unterschied zwischen Volumen- und SOI-Material liegt in der Dicke der Funktionsschicht.

Das Bändermodell als solches bleibt natürlich auch für eine dünne Schicht erhalten. Allerdings verändert sich das Verhältnis der Raumladungszonenweite zur Dicke der Siliciumschicht. Kann sich die Raumladungszone im Volumenmaterial über die gesamte Dicke der Siliciumscheibe erstrecken (Fig. 3), so ist sie im Fall einer SOI-Scheibe auf die Dicke der Funktionsschicht begrenzt (Fig. 4). Für den beschriebenen Widerstandsbereich ist somit die Raumladungszone im Volumenmaterial um mindestens eine Größenordnung größer als die Dicke der Funktionsschicht einer SOI-Scheibe.

Da im Falle von SOI nur die Ladungsträger innerhalb der Funktionsschicht betrachtet werden müssen, ist auch die Bandverbiegung und die Raumladungszonenweite entsprechend geringer. Dadurch wird das Redoxpotential an der Grenzfläche zwischen Ätzmittel und Silicium verschoben, was einen entsprechenden Einfluss auf die möglichen Reaktionen hat.

Die Modellvorstellungen zum Prozess des Auflösens von Silicium mittels Flusssäure bleiben auch für dünne Siliciumschichten voll erhalten. Die Auflösung des Siliciums findet auch an der Oberfläche der Funktionsschicht über einen der beiden Mechanismen statt, als direkte oder indirekte Auflösung. Die hierfür benötigten Löcher (h⁺, "Defektelektronen") werden aus der Funktionsschicht zur Verfügung gestellt. Dies kann jetzt allerdings nur aus einem stark begrenzten Reservoir erfolgen, da deren Zahl proportional zum Volumen des vorhandenen Siliciums verläuft. Werden durch die Reaktion an der Grenzfläche mehr Löcher aus dem Silicium entnommen, als thermisch nachgeneriert werden können, so sinkt die absolute Zahl der Löcher in der Funktionsschicht, bis jedes generierte Loch sofort an die Grenzfläche beschleunigt wird. Für eine schnelle Reaktion bedeutet dies, dass sich die Raumladungszone über die gesamte Dicke der Funktionsschicht erstrecken würde. Verläuft die Reaktion langsamer, so kann auch die Raumladungszonenweite geringer sein, wodurch ein Teil der Funktionsschicht weiterhin freie bewegliche Ladungsträger besitzt.

Die Weite der Raumladungszone innerhalb der Funktionsschicht ist entscheidend für die Eigenschaften der Funktionsschicht. Im Normalfall führt die Bandverbiegung zu einer Verarmung an Löchern bzw. Elektronen an der Grenzfläche. Aufgrund des anschließenden Flachbandpotentials können nicht alle Ladungsträger dem Potentialverlauf folgen. Breitet sich die Bandverbiegung aber über das gesamte Volumen aus, so fällt das Potential über diesem ab. Eine völlige Entleerung an Ladungsträgern ist demnach möglich. Diese Situation tritt z.B. beim Ätzen einer SOI-Scheibe mit einer Halbleiterschicht von 100 nm Dicke mit einer Ätzlösung aus 48%iger HF mit H₂O₂ mit pH-Wert 1 bei Raumtemperatur ein: Die Halbleiterschicht bleibt bei einer Ätzzeit von einer Stunde erhalten, d.h. die Enddicke der Halbleiterschicht ist bei Verwendung der genannten Ätzlösung größer als 100 nm. Unter diesen Bedingungen wären bei Volumenmaterial mehrere µm geätzt worden.

Die klassische Kombination aus Flusssäure (HF) und Salpetersäure (HNO₃) löst die Siliciumschicht bei Raumtemperatur ebenfalls nicht auf. Erst eine Temperaturerhöhung auf ca. 50 °C führt innerhalb von Sekunden zum gewünschten Ergebnis. Kombinationen mit schwächeren Oxidationsmitteln wie Phosphorsäure (H₃PO₄) oder Wasserstoffperoxid (H₂O₂) ätzen die Siliciumschicht bei Raumtemperatur nicht und bei höheren Temperaturen nur sehr langsam. Umgekehrt ist das vollständige Abtragen der Siliciumschicht mit starken Oxidationsmitteln wie z.B. Chromsäure innerhalb kürzester Zeit möglich.

Für ein partielles Ätzen der Funktionsschicht sind deshalb geeignete Ätzmittel notwendig. Geeignete Ätzmittel müssen in der Funktionsschicht eine Bandverschiebung derart erzeugen, dass das Flachbandpotential in der Funktionsschicht erhalten bleibt.

Für die betrachteten SOI-Scheiben ist Ammoniumfluorid (NH₄F) ein geeignetes Ätzmittel. Vom Volumenmaterial her ist bekannt, dass eine NH₄F-Lösung erheblich langsamer ätzt als eine HF-Lösung. Bei der dünnen Siliciumschicht einer SOI-Scheibe kehrt sich dieses Verhältnis um: Bei einer 100 nm dicken SOI-Schicht können anfänglich Ätzraten von einigen nm/min bei Raumtemperatur erreicht werden.

Der Unterschied zwischen einer Ammoniumfluorid- und einer Fluorwasserstofflösung liegt - neben den verschiedenen Kationen - im pH-Wert der Lösung. Eine HF-Lösung besitzt einen pH-Wert von ca. 1 und eine NH₄F-Lösung einen pH-Wert von ca. 7. Der unterschiedliche pH-Wert führt zu einer Verschiebung des chemischen Potentials der NH₄F-Lösung im Vergleich zur HF-Lösung. Aus der Literatur ist bekannt, dass sich mit dem pH-Wert auch die Bandverbiegung im Silicium linear verändert. Das chemische Potential der NH₄F-Lösung passt wesentlich besser zum Potential der Bandverbiegung des Siliciums der Funktionsschicht als das Potential einer HF-Lösung. Gleichzeitig verläuft die Reaktion langsam und es werden nur wenige Löcher pro Zeiteinheit benötigt, woraus eine geringere Raumladungszonenweite in der Funktionsschicht resultiert. Das Flachbandpotential bleibt in der Funktionsschicht erhalten (Fig. 6). Die Ätzung der Funktionsschicht verläuft demnach analog zu der von Volumenmaterial. Im Vergleich zur Ätzung von Volumenmaterial mit einer HF-Lösung erscheint sie jedoch deutlich schneller.

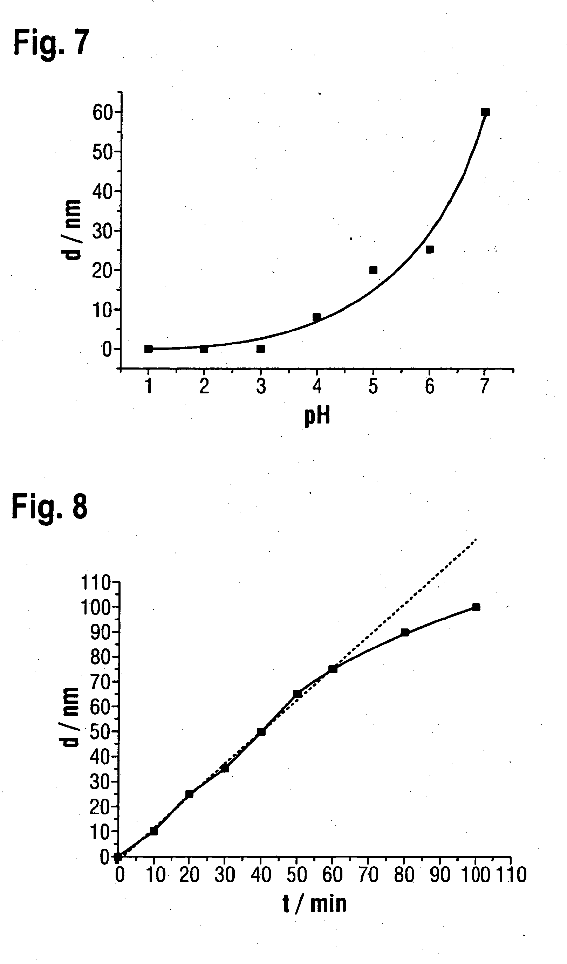

Die Einstellung des pH-Wertes eröffnet die Möglichkeit, die Wirkung des Ätzmittels weiter zu optimieren. So kann z.B. durch Mischung von HF- und NH₄F-Lösungen der pH-Wert und damit die Ätzgeschwindigkeit variiert werden. Der Einfluss des pH-Werts auf die Ätzgeschwindigkeit wurde anhand einer Mischreihe aus einer 5%igen HF-Lösung und einer 5%igen NH₄F-Lösung untersucht. Aus diesen beiden Lösungen können mittels verschiedener Mischungsverhältnisse alle pH-Werte zwischen 1 und 7 eingestellt werden, ohne dabei die Konzentration an FluoridIonen zu beeinflussen. SOI-Scheiben mit einer Siliciumschicht mit einer anfänglichen Dicke von 100 nm wurden in den so hergestellten Ätzlösungen mit jeweils unterschiedlichem pH-Wert für eine definierte Zeit (5 Minuten) geätzt. Die Temperatur wurde bei 25 °C gehalten. In Fig. 7 ist ein exponentieller Anstieg der Ätztiefe d (in nm) mit steigendem pH-Wert zu erkennen, was einem exponentiellen Anstieg der Ätzrate mit dem pH-Wert entspricht. Für pH=7 wird ein Maximum von 12 nm/min erreicht, das aber durch Konzentrations- und Temperaturänderungen auch weiter nach oben verschoben werden kann. Das Verhalten auf eine pH-Wert-Verschiebung ist demnach invers zum Verhalten im Fall von Volumenmaterial. Das Redoxpotential an der Grenzfläche ist zu Gunsten einer Reaktion mit Ammoniumfluorid verschoben. Eine HF-NH₄F-Lösung ist also im Stande, die Funktionsschicht bei Raumtemperatur mit einer einstellbaren Ätzrate von 1 bis 12 nm/min abzutragen.

Wenn die Funktionsschicht mit fortschreitender Ätzung immer dünner wird, kommt am Ende derselbe Effekt zum Tragen, der auch für die Flusssäure gefunden wurde: Die Zahl der in der dünnen Funktionsschicht verbleibenden Ladungsträger wird immer geringer, wodurch auch die Bandverbiegung immer schwächer ausfällt. Damit verbunden ist eine Verschiebung des Redoxpotentials an der Grenzfläche. Aufgrund dieser Verschiebung verringert sich die Ätzrate, bis eine Reaktion mit der Ammoniumfluorid-Lösung nicht mehr möglich ist.

Die Untersuchung der Ätztiefe an SOI-Scheiben in Abhängigkeit von der Reaktionszeit bestätigt diese Hypothese. In Fig. 8 ist die Ätztiefe d (in nm) nach unterschiedlichen Ätzzeiten t (in min) für die 100 nm dicke Siliciumschicht einer SOI-Scheibe dargestellt. Die Ätzlösung besteht aus einer Mischung aus 10 % wässriger HF und 10 % wässriger NH₄F mit einem pH-Wert von 5,5. Die Ätztemperatur wurde bei 25 °C gehalten. Es ist eine klare lineare Abhängigkeit der Ätztiefe von der Reaktionszeit zu erkennen, bis eine Tiefe von ca. 75 nm nach etwa 60 min Ätzzeit überschritten wird. Von dort an beginnt sich die Ätzrate zu verringern. Extrapoliert man die anfängliche Ätzrate, so müsste nach 80 min Ätzzeit die gesamte 100 nm dicke Halbleiterschicht weggeätzt sein. Aber selbst bei einer Ätzzeit von 100 min bleibt eine dünne Siliciumschicht erhalten, was daran zu erkennen ist, dass das Oxid nicht angegriffen wird.

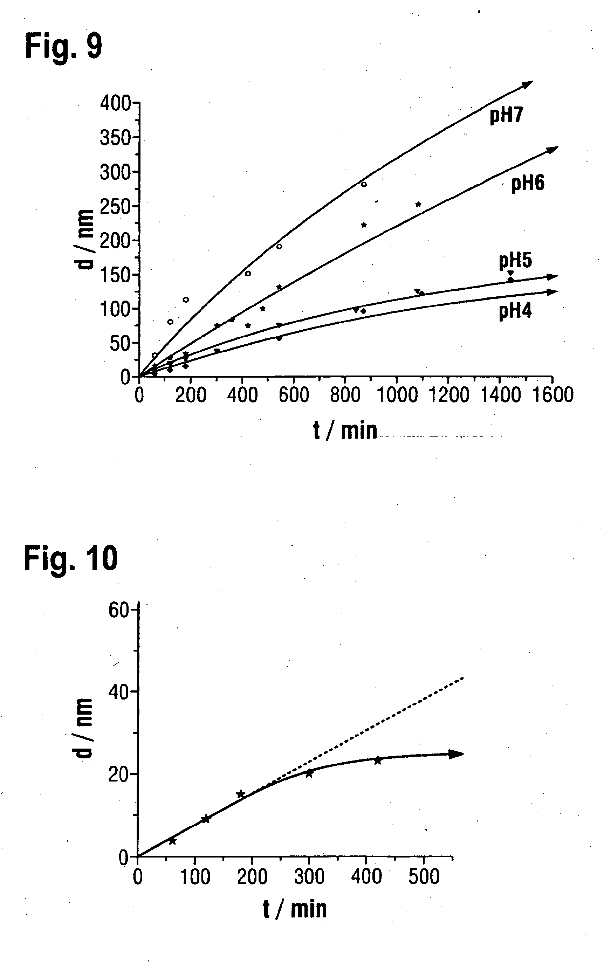

Fig. 9 beschreibt die Entwicklung der Ätztiefen d (in nm) als Funktion der Ätzdauer t (in min) an SOI-Scheiben mit einer 2200 nm dicken Halbleiterschicht, die mit Hilfe von Ätzlösungen mit unterschiedlichen pH-Werten geätzt wurden. Die pH-Werte der Ätzlösungen wurden jeweils durch Mischen von 5 % wässriger HF- und 5 % wässriger NH₄F-Lösungen in geeigneten Verhältnissen hergestellt. Die Temperatur wurde bei 10 °C gehalten. Es zeigt sich, dass die Ätzwirkung mit zunehmender Ätzzeit abnimmt, d.h. dass die Ätzrate mit abnehmender Dicke der Halbleiterschicht abnimmt. Die Ätztiefen streben bei zunehmender Ätzzeit unterschiedliche Grenzwerte an, d.h. mit unterschiedlichem pH-Wert der Ätzlösung lassen sich unterschiedliche Enddicken der Siliciumschicht erreichen.

Diese Eigenschaft von Ammoniumfluorid-Lösungen lässt sich als Ätzstopp für SOI-Scheiben verwenden, indem die dünner werdende Funktionsschicht sich selbst daran hindert, durchbrochen zu werden. Die Tiefe der Ätzstoppwirkung kann durch Einstellung des pH-Werts reguliert werden.

Fig. 10 zeigt, wie eine SOI-Scheibe mit einer anfänglich 100 nm dicken Halbleiterschicht kontrolliert gedünnt werden kann. Eine wässrige Ätzlösung, bei der durch Mischung von 5% wässriger HF und 5% wässriger NH₄F in geeignetem Verhältnis ein pH-Wert von 4 eingestellt wurde, ätzt bei einer Temperatur von 10 °C maximal etwa 25 nm (Ätztiefe d ≈ 25 nm bei langer Ätzdauer t), d.h. die Dicke der Halbleiterschicht kann kontrolliert auf 75 nm reduziert werden. Durch Änderung des pH-Wertes lässt sich diese Dicke steuern. So wird z.B. mit einem pH-Wert von 5 die Halbleiterschicht auf eine Enddicke von etwa 50 nm reduziert.

## Patentansprüche

1. Verfahren zur Verringerung und Homogenisierung der Dicke einer Funktionsschicht aus Silicium, die sich auf der Oberfläche eines elektrisch isolierenden Materials befindet und die Funktionsschicht einer SOI-Scheibe ist, wobei ein Ätzmittel auf die Oberfläche der Funktionsschicht einwirkt, das Fluorwasserstoff und ein Fluoridsalz enthält und dessen Redoxpotential in Abhängigkeit von der gewünschten Enddicke der Funktionsschicht so eingestellt ist, dass der durch das Ätzmittel an der Oberfläche der Funktionsschicht pro Zeiteinheit bewirkte Materialabtrag mit abnehmender Dicke der Funktionsschicht geringer wird und bei der gewünschten Enddicke nur mehr 0 bis 10 % der Dicke pro Sekunde beträgt, und wobei die Verringerung und Homogenisierung der Dicke der Funktionsschicht durch eine Ätzreaktion des Ätzmittels herbeigeführt wird und ohne den Gebrauch von Lichtquellen, die durch das Erzeugen von Ladungsträgern in der Funktionsschicht signifikant zur Ätzreaktion beitragen, oder das Anlegen einer externen elektrischen Spannung durchgeführt wird.

2. Verfahren gemäß Anspruch 1, **dadurch gekennzeichnet, dass** das Redoxpotential des Ätzmittels durch die Zusammensetzung des Ätzmittels eingestellt wird.

3. Verfahren gemäß Anspruch 2, **dadurch gekennzeichnet, dass** das Redoxpotential des Ätzmittels durch die Wahl der Komponenten des Ätzmittels eingestellt wird.

4. Verfahren gemäß Anspruch 2, **dadurch gekennzeichnet, dass** das Redoxpotential des Ätzmittels durch die Konzentrationen der Komponenten des Ätzmittels eingestellt wird.

5. Verfahren gemäß Anspruch 4, **dadurch gekennzeichnet, dass** das Redoxpotential des Ätzmittels im Wesentlichen durch seinen pH-Wert bestimmt wird und dass die Konzentrationen der Komponenten des Ätzmittels so gewählt werden, dass ein geeigneter pH-Wert eingestellt wird.

6. Verfahren gemäß einem der Ansprüche 2 bis 5, **dadurch gekennzeichnet, dass** das Redoxpotential zusätzlich durch die Wahl der Temperatur eingestellt wird.

7. Verfahren gemäß einem der Ansprüche 1 bis 6, **dadurch gekennzeichnet, dass** das Fluoridsalz Ammoniumfluorid ist.

8. Verfahren gemäß einem der Ansprüche 1 bis 7, **dadurch gekennzeichnet, dass** die Funktionsschicht aus p-dotiertem Silicium besteht.

9. Verfahren gemäß einem der Ansprüche 1 bis 8, **dadurch gekennzeichnet, dass** der durch das Ätzmittel an der Oberfläche der Funktionsschicht pro Zeiteinheit bewirkte Materialabtrag bei der gewünschten Enddicke 0 bis 1 nm pro Sekunde beträgt.

## Claims

1. Method for reducing and homogenizing the thickness of a functional silicon layer which lies on the surface of an electrically insulating material and is the functional layer of an SOI wafer, wherein the surface of the functional layer is exposed to the action of an etchant which contains hydrogen fluoride and a fluoride salt and whose redox potential is adjusted as a function of the desired final thickness of the functional layer, so that the material erosion per unit time on the surface of the functional layer due to the etchant becomes less as the thickness of the functional layer decreases and is only from 0 to 10% of the thickness per second when the desired final thickness is reached, and wherein the reduction and homogenization of the thickness of the functional layer is brought about by an etching reaction of the etchant and is carried out without the use of light sources which, by generating charge carriers in the functional layer, contribute significantly to the etching reaction, or the application of an external electrical voltage.

2. Method according to Claim 1, **characterized in that** the redox potential of the etchant is adjusted via the composition of the etchant.

3. Method according to Claim 2, **characterized in that** the redox potential of the etchant is adjusted via the choice of the constituents of the etchant.

4. Method according to Claim 2, **characterized in that** the redox potential of the etchant is adjusted via the concentrations of the constituents of the etchant.

5. Method according to Claim 4, **characterized in that** the redox potential of the etchant is determined essentially by its pH, and **in that** the concentrations of the constituents of the etchant are selected so that a suitable pH is adjusted.

6. Method according to one of Claims 2 to 5, **characterized in that** the redox potential is additionally adjusted via the choice of the temperature.

7. Method according to one of Claims 1 to 6, **characterized in that** the fluoride salt is ammonium fluoride.

8. Method according to one of Claims 1 to 7, **characterized in that** the functional layer consists of p-doped silicon.

9. Method according to one of Claims 1 to 8, **characterized in that** the material erosion per unit time on the surface of the functional layer due to the etchant is from 0 to 1 nm per second when the desired final thickness is reached.

## Revendications

1. Procédé pour la réduction et l'homogénéisation de l'épaisseur d'une couche fonctionnelle en silicium, qui se trouve à la surface d'un matériau électriquement isolant et qui est la couche fonctionnelle d'une tranche SOI, un agent de gravure, contenant de l'acide fluorhydrique et un sel de fluorure, agissant sur la surface de la couche fonctionnelle et présentant un potentiel redox réglé en fonction de l'épaisseur finale souhaitée de la couche fonctionnelle de manière telle que l'enlèvement de matière provoqué par unité de temps par l'agent de gravure à la surface de la couche fonctionnelle diminue avec l'épaisseur décroissante de la couche fonctionnelle et ne représente plus que 0 à 10% de l'épaisseur par seconde à l'épaisseur finale souhaitée, et la réduction et l'homogénéisation de l'épaisseur de la couche fonctionnelle étant provoquées par une réaction de gravure de l'agent de gravure et réalisées sans utilisation de sources de lumière qui contribuent significativement à la réaction de gravure par la génération de supports de charge dans la couche fonctionnelle ou l'application d'une tension électrique externe.

2. Procédé selon la revendication 1, **caractérisé en ce que** le potentiel redox de l'agent de gravure est réglé par la composition de l'agent de gravure.

3. Procédé selon la revendication 2, **caractérisé en ce que** le potentiel redox de l'agent de gravure est réglé par le choix des composants de l'agent de gravure.

4. Procédé selon la revendication 2, **caractérisé en ce que** le potentiel redox de l'agent de gravure est réglé par les concentrations des composants de l'agent de gravure.

5. Procédé selon la revendication 4, **caractérisé en ce que** le potentiel redox de l'agent de gravure est essentiellement déterminé par son pH et **en ce que** les concentrations des composants de l'agent de gravure sont choisies de manière telle qu'un pH approprié est réglé.

6. Procédé selon l'une quelconque des revendications 2 à 5, **caractérisé en ce que** le potentiel redox est en outre réglé par le choix de la température.

7. Procédé selon l'une quelconque des revendications 1 à 6, **caractérisé en ce que** le sel de fluorure est le fluorure d'ammonium.

8. Procédé selon l'une quelconque des revendications 1 à 7, **caractérisé en ce que** la couche fonctionnelle est en silicium dopé de type p.

9. Procédé selon l'une quelconque des revendications 1 à 8, **caractérisé en ce que** l'enlèvement de matière provoqué par unité de temps par l'agent de gravure à la surface de la couche fonctionnelle à l'épaisseur finale souhaitée est de 0 à 1 nm par seconde.
